# FASCICULE DE BREVET EUROPEEN

(11) **EP 0 637 843 B1**
(45) Date de publication et mention de la délivrance du brevet: **13.10.1999**
(21) Numéro de dépôt: 94410062.7
(22) Date de dépôt: 03.08.1994
(51) Int. Cl.: H01L 27/02, H02H 9/04

(54) **Circuit de protection contre des surtensions**
Überspannungsschutzschaltung
Overvoltage protection circuit

(30) Priorité: 06.08.1993 FR 9309928
(43) Date de publication de la demande: 08.02.1995
(73) Titulaire: STMicroelectronics S.A., 94250 Gentilly (FR)
(72) Inventeur: Gens, Marc, F-38400 Saint Martin d'Uriage (FR); Jimenez, Jean, F-38500 Voiron (FR)
(74) Mandataire: de Beaumont, Michel

(56) Documents cités:
- EP-A- 0 148 577
- EP-A- 0 435 047
- US-A- 5 034 845
- REVUE GENERALE DE L'ELECTRICITE, no.2, Février 1987, PARIS FR pages 19 - 24, XP52078 C. CHAPRON 'LES CIRCUITS INTEGRES BIPOLAIRES : COMMENT DIMINUER LEUR SENSIBILITE AUX DECHARGES ELECTROSTATIQUES'
- PATENT ABSTRACTS OF JAPAN vol. 9, no. 53 (E-301) (1776) 7 Mars 1985 & JP-A-59 191 371 (NIPPON DENKI) 30 Octobre 1984

## Description

Les circuits intégrés comprennent divers composants qui sont susceptibles d'être détruits par l'apparition de surtensions. Un problème particulier réside dans la protection des bornes d'un circuit intégré lors de ses étapes finales de fabrication ou de manipulation avant montage à l'encontre de surcharges électrostatiques. Ces surcharges électrostatiques sont par exemple provoquées par le contact avec deux plots ou broches du circuit intégré d'un outil de manipulation ou de doigts d'un opérateur.

Il convient de souligner que les systèmes de protection contre des surcharges électrostatiques doivent être actifs alors même que le circuit intégré n'est pas connecté, et notamment que ses bornes de masse ne sont pas reliées entre elles. De plus, ces systèmes de protection contre des décharges électrostatiques ne doivent bien entendu pas affecter le fonctionnement du circuit intégré une fois qu'il est connecté.

La figure 1A, qui correspond à l'état de la technique décrit dans EP-A-0 148 577, représente un schéma classique de protection contre des décharges électrostatiques d'un circuit intégré comprenant une seule source d'alimentation connectée entre un plot d'alimentation haute VDD₁ et un plot d'alimentation basse VSS₁. Chacun des plots d'entrée/sortie P1 à Pn du circuit est relié à un rail conducteur R1 connecté au plot d'alimentation haute VDD₁ par l'intermédiaire d'une diode d'isolement D1 dont l'anode est connectée au plot et la cathode au rail R1. Chacun des plots P1 à Pn est également relié à un rail R2 connecté au plot VSS₁ par l'intermédiaire d'une diode d'isolement D2 dont la cathode est reliée au plot et l'anode au rail R2. Le rail R1 est connecté au rail R2 par un dispositif d'écrêtage symbolisé sous forme d'une diode à avalanche Z1 dont la cathode est reliée au rail R1 et l'anode au rail R2. Tout système écrêteur unidirectionnel classique peut être utilisé comme dispositif d'écrêtage Z1. Cet écrêteur a une tension de seuil d'avalanche supérieure à VDD₁-VSS₁ mais bien entendu inférieure à la valeur de la surtension à l'encontre de laquelle on veut protéger les éléments du circuit intégré.

En pratique, puisqu'il s'agit d'un circuit intégré, les diodes D1, D2 et l'écrêteur Z1 sont réalisés à l'intérieur du circuit intégré et les rails R1 et R2 sont des métallisations formées sur ce circuit intégré. On notera que les éléments correspondants aux diodes D1 et D2 sont de relativement faible surface mais que, par contre, la réalisation de l'écrêteur Z1 nécessite l'occupation d'une surface relativement importante du circuit intégré.

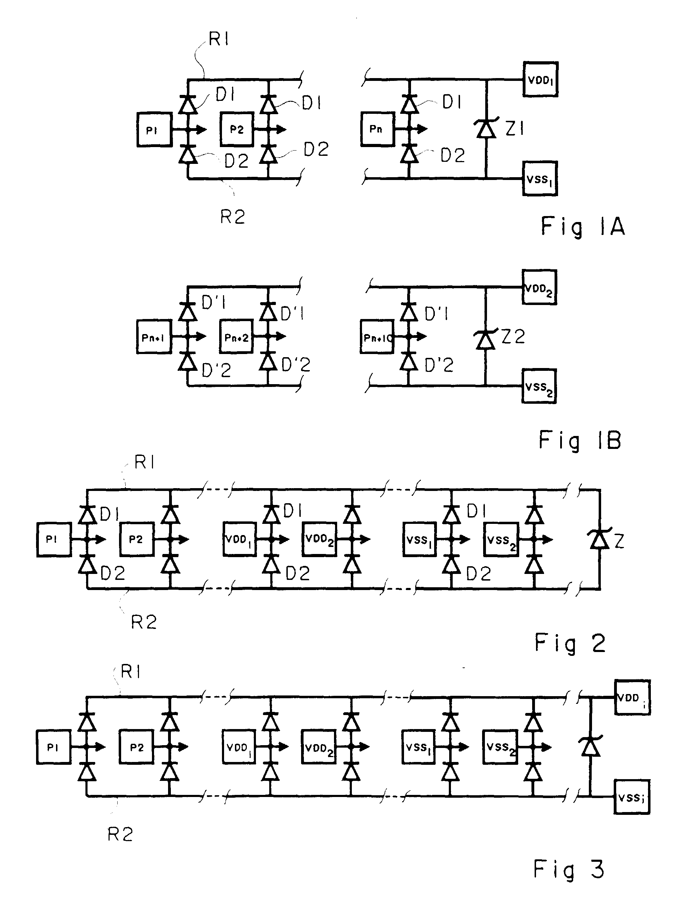

Le circuit de la figure 1A donne satisfaction quant à la protection à l'encontre de décharges électrostatiques quand le circuit intégré présente une seule source d'alimentation externe.

Ce circuit présente toutefois un inconvénient lors du fonctionnement du circuit intégré à savoir que, puisque chacun des plots est relié à la tension d'alimentation haute par une diode en direct et à la tension d'alimentation basse par une diode en inverse, chacun des plots ne peut monter à plus de 0,6 volt au-dessus de la tension haute ou descendre à plus de -0,6 volt en dessous de la tension basse VSS (couramment la masse). Or, il est souhaitable que la tension d'un plot puisse monter dans certains cas au-dessus de la tension d'alimentation la plus haute. Par exemple, lors du fonctionnement d'un circuit intégré, si la tension d'alimentation haute est coupée et reliée à la masse et que l'un des plots est associé à une capacité de mémorisation, cette capacité se déchargera par l'une des diodes D1 vers le plot d'alimentation VDD₁. Egalement, des amplificateurs de sortie peuvent être connectés à des charges inductives ; s'il se produit des surtensions, celles-ci seront écrêtées par la connexion vers la borne d'alimentation haute, ce qui peut ne pas être souhaitable.

Les circuits intégrés modernes comprennent souvent plusieurs sources d'alimentation (jusqu'à 7 pour certains circuits). Chacune de ces sources d'alimentation comprend une borne d'alimentation haute VDDi et une borne d'alimentation basse VSSᵢ.

De façon classique, pour protéger un circuit à plusieurs souroes d'alimentation, on a simplement étendu le circuit de la figure 1A en le dupliquant par des circuits tels que celui de la figure 1B, comme le décrit par exemple US-A-5 034 845. Les plots P1 à Pn, faisant partie de portions de circuit reliées à une première source d'alimentation VDD₁-VSS₁, sont connectés par le circuit de la figure 1A ; et les plots Pₙ₊₁ à Pₙ₊ₖ, faisant partie de portions de circuit reliées à une deuxième souroe d'alimentation VDD₂-VSS₂, sont connectés par un circuit analogue à celui de la figure 1A, illustré en figure 1B. Ce type de circuit est répété autant de fois qu'il y a de sources d'alimentation.

L'utilisation de ce type de protection pour des circuits intégrés à plusieurs souroes d'alimentation présente plusieurs inconvénients majeurs.

Un premier inconvénient est que cette structure nécessite autant d'écrêteurs Zi qu'il y a de sources d'alimentation. Or, comme on l'a remarqué précédemment, ces écrêteurs occupent une surface relativement importante du circuit intégré et ceci est contradictoire avec la volonté de réduction de surface qui s'impose à tout concepteur de circuit intégré.

Un deuxième inconvénient encore plus important de l'utilisation simultanée de circuits tels que ceux des figures lA et 1B dans un même circuit intégré est que ce type de protection est inefficace quand une décharge électrostatique est provoquée entre un plot P1 à Pn associé à une première source d'alimentation et un plot Pₙ₊₁ à Pₙ₊ₖ associé à une deuxième source d'alimentation. Il n'existe alors plus de trajet passant par un écrêteur pour court-circuiter la surcharge. Celle-ci se propage alors à l'intérieur du circuit intégré et peut avoir un effet destructeur.

Ainsi, un objet de la présente invention est de prévoir pour un circuit intégré à plusieurs alimentations, une structure de protection contre des décharges électrostatiques entre des plots ou des broches qui soit parfaitement efficace alors que ce circuit intégré n'est pas connecté.

Un autre objet de la présente invention est de prévoir une telle structure de protection qui permette en outre aux plots de monter à une tension supérieure à la tension d'alimentation la plus haute ou de descendre à une tension inférieure à la tension d'alimentation la plus basse.

Un autre objet de la présente invention est de prévoir une telle structure de protection qui occupe une surface réduite.

Pour atteindre ces objets, la présente invention prévoit un circuit de protection selon la revendication 1. Des modes spécifiques de réalisation de la présente invention sont décrits dans les revendications dépendantes.

Ces objets, caractéristiques et avantages ainsi que d'autres de la présente invention seront exposés en détail dans la description suivante de modes de réalisation particuliers faite à titre non limitatif en relation avec les figures jointes parmi lesquelles :
la figure 1A représente une structure classique de protection électrostatique des plots d'un circuit intégré à une seule source d'alimentation ;
les figures 1A et 1B prises ensembles représentent une structure classique de protection électrostatique des plots d'un circuit intégré associé à deux souroes d'alimentation ;
la figure 2 représente une structure de protection électrostatique de plots de circuit intégré selon la présente invention ;
la figure 3 représente une variante de structure de protection électrostatique de plots de circuit intégré selon la présente invention ; et
la figure 4 représente de façon très schématique une portion d'une puce de circuit intégré incorporant une structure de protection électrostatique selon la présente invention.

La figure 2 représente schématiquement un circuit de protection contre des surcharges électrostatiques selon la présente invention d'un circuit intégré associé à plusieurs alimentations. Ces alimentations sont chacune appliquée entre des bornes d'alimentation haute VDD₁, VDD₂... et basse VSS₁, VSS₂.... Le circuit intégré comprend aussi des plots d'entrée/ sortie classiques P1, P2.... Le circuit de protection selon la présente invention comprend comme précédemment des rails R1 et R2 respectivement connectés à la cathode et à l'anode d'un écrêteur Z. Comme précédemment, chacun des plots P1, P2... est connecté au rail R1 par une diode D1 polarisée en direct et au rail R2 par une diode D2 polarisée en inverse. Mais en outre, selon la présente invention, chacun des plots d'alimentation haute et basse VDD₁, VDD₂..., VSS₁, VSS₂... est également connecté à ces rails R1 et R2 par des diodes D1 et D2 respectivement polarisées en direct et en inverse. Dans le mode de réalisation de la figure 2, les rails R1 et R2 sont maintenus flottants.

Ainsi, selon la présente invention, toute décharge entre l'un quelconque des plots P1, P2..., et un autre quelconque de ces plots ou l'un quelconque des plots d'alimentation haute ou basse passera par une diode D1, le dispositif écrêteur Z et une diode D2.

Ce type de protection assure donc une protection complète contre les décharges électrostatiques entre deux plots quelconques du circuit intégré.

Un avantage de la structure de protection selon la présente invention est qu'elle comprend un seul écrêteur Z quel que soit le nombre d'alimentations du circuit. Ceci entraîne une réduction de surface.

Un autre avantage de cette disposition est que l'un quelconque des plots P1, P2... peut, lors du fonctionnement du circuit intégré, passer à une tension supérieure à celle de la borne d'alimentation haute la plus élevée ou inférieure à celle de la borne d'alimentation basse la plus faible. En effet, la différence de tension entre deux plots est toujours limitée par la tension d'écrêtage de l'écrêteur Z (additionnée de deux chutes de tension en direct de diodes).

La figure 3 illustre une variante de réalisation de la présente invention dans laquelle on retrouve sensiblement la même structure que celle de la figure 2 mais où le plot devant être relié à la tension haute de valeur la plus élevée VDDᵢ est connecté au rail R1 et le plot devant être relié à la tension basse de valeur la plus faible VSSⱼ est connecté au rail R2. Cette variante assure également une protection contre toutes les configurations de surtension. Elle permet par rapport au mode de réalisation précédent d'économiser quatre diodes d'isolement qui seraient associées dans le mode de réalisation de la figure 2 aux plots VDDᵢ et VSSⱼ. Elle présente toutefois l'inconvénient de ne plus permettre à l'un des plots P1, P2... de monter notablement au-dessus de la tension la plus haute ou de descendre notablement en dessous de la tension la plus basse.

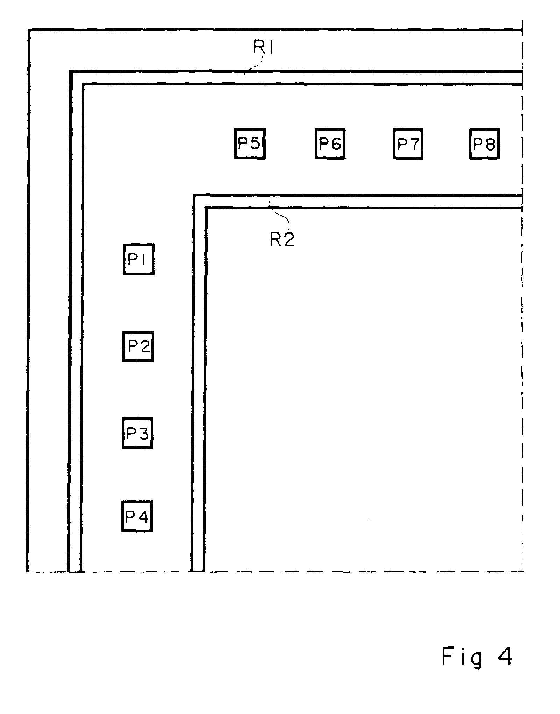

La figure 4 est une vue de dessus très schématique d'une portion d'un circuit intégré où l'on a représenté des plots P1 à P8 qui peuvent être aussi bien des plots d'entrée/ sortie que des plots d'alimentation. De façon classique, ces plots sont disposés à la périphérie du circuit intégré. De préférence, les rails R1 et R2 sont également disposés à la périphérie de la puce de circuit intégré, au voisinage des plots, respectivement en deçà et au-delà de ceux-ci par rapport au centre de la puce. Les plots seront reliés à ces rails par les diodes intégrées dans le circuit d'une façon classique.

La présente invention est susceptible de nombreuses variantes de réalisation qui apparaîtront à l'homme de l'art. Par exemple, dans le cas d'un circuit intégré à plusieurs sources d'alimentation dans lequel les diverses sources sont isolées les unes des autres mais sont toutes de même valeur, chacun des plots d'alimentation haute pourra être relié au rail relié à la cathode du dispositif de protection par l'intermédiaire d'une paire de diodes en anti-parallèle et chacun des plots d'alimentation basse pourra être relié au rail relié à l'anode de l'écrêteur par l'intermédiaire également d'une paire de diodes en anti-parallèle.

## Revendications

1. Circuit de protection contre des surtensions électrostatiques des plots de connexion d'un circuit intégré à alimentations multiples, chaque alimentation étant connectée entre un plot de connexion à potentiel haut et un plot de connexion à potentiel bas, le circuit de protection comprenant :
- une pluralité de plots de connexion d'un circuit intégré à alimentations multiples se répartissant en une pluralité de plots d'entrée/sortie (P₁, P₂ ...), et en une pluralité de plots d'alimentation consistant en une pluralité de plots de connexion à potentiel haut (VDD₁, VDD₂..., .., VDDᵢ, ...) et une pluralité de plots de connexion à potentiel bas (VSS₁, VSS₂, ..., VSSⱼ, ...),
- une pluralité de premières diodes (D1),
- une pluralité de deuxièmes diodes (D2),
- un composant écrêteur unidirectionnel (Z),
- un premier rail conducteur (R1),
- un deuxième rail conducteur (R2) ;
le circuit de protection étant de plus tel que :
- dans l'ensemble formé par tous les plots d'entrée-sortie (P1, P2, ...) et certains des plots d'alimentation (VDD₁, VDD₂, ..., VSS₁, VSS₂, ..., chaque plot est connecté à l'anode d'une des premières diodes (D1) dont la cathode est reliée au premier rail conducteur (R1) et à la cathode d'une des deuxièmes diodes (D2) dont l'anode est reliée au deuxième rail conducteur (R2), et
- le composant écrêteur unidirectionnel (Z) est connecté par sa cathode au premier rail conducteur (R1) et par son anode au deuxième rail (R2).

2. Circuit de protection selon la revendication 1, caractérisé en ce que tous les plots d'alimentation sont connectés aux premières et deuxièmes diodes de la façon indiquée en revendication 1 pour lesdits certains des plots d'alimentation.

3. Circuit de protection selon la revendication 1, caractérisé en ce que le plot (VDDᵢ) au potentiel haut de l'alimentation la plus positive est connecté au premier rail et le plot (VSSⱼ) à potentiel bas de l'alimentation la plus négative est connecté au deuxième rail.

4. Circuit de protection selon la revendication 1, caractérisé en ce que les rails (R1, R2) sont constitués de pistes conductrices formées à la périphérie du circuit intégré, respectivement en-deçà et au-delà des plots de connexion.

## Claims

1. A circuit for protecting pads of an integrated circuit associated with a plurality of power supply sources against electrostatic overvoltages, each power supply being connected between a high voltage pad and a low voltage pad, the circuit comprising:
a plurality of connecting pads of an integrated circuit with a plurality of power supply sources distributed between a plurality of input/output pads (P1, P2,...) and a plurality of supply pads consisting of a plurality of connection pads to a high potential (VDD₁, VDD₂,..., VDDᵢ,...) and a plurality of connection pads to a low potential (VSS₁, VSS₂, ..., VSSⱼ,...),
a plurality of first diodes (D1),
a plurality of second diodes (D2),
a unidirectional clipping component (Z),
a first conductive bus (R1),
a second conductive bus (R2);
the protection pad further being such that:
- in the set formed by all the input/output pads (P1, P2,...) and some of the supply pads (VDD₁, VDD₂,..., VSS₁, VSS₂,...), each pad is connected to the anode of one of the first diodes (D1), the cathode of which is connected to the first conductive bus (R1), and to the cathode of one of the second diodes (D2), the anode of which is connected with the second conductive bus (R2), and
- the unidirectional clipping component (Z) is connected by its cathode to the first conductive bus (R1) and by its anode to the second conductive bus (R2).

2. The protection circuit of claim 1, characterized in that all the power supply pads are connected to the first and second diodes in the way indicated in claim 1, for said some of the supply pads.

3. The protection circuit of claim 1, characterized in that the high voltage pad (VDDᵢ) of the highest power supply source is connected to the first bus, and the low voltage pad (VSSⱼ) of the lowest power supply source is connected to the second bus.

4. The protection circuit of claim 1, characterized in that the buses (R1, R2) are constituted by conductive paths that are formed at the periphery of the integrated circuit, inside and beyond the connecting pads, respectively.

## Patentansprüche

1. Schutzschaltung zum Schutz der Anschlußkontakte bzw. -kontaktflecken einer integrierten Schaltung mit Mehrfach-Versorgungsspeisung gegen elektrostatische Überspannungen, wobei jeweils jede Versorgung zwischen einem Hochpotential-Anschlußkontakt und einem Niedrigpotential-Anschlußkontakt angeschlossen ist, die Schutzschaltung umfassend:
- eine Mehrzahl von Anschlußkontakten einer integrierten Schaltung mit Mehrfachspeisung, die sich auf eine Mehrzahl von Eingangs-/Ausgangs-Anschlußkontakten (P₁,P₂,...) und eine Mehrzahl von Versorgungs-Anschlußkontakten verteilen, die ihrerseits aus einer Mehrzahl von Hochpotential-Anschlußkontakten (VDD₁, VDD₂, .... VDDᵢ,..) und einer Mehrzahl von Niedrigpotential- Anschlußkontakten (VSS₁, VSS₂ .....VSSⱼ,....) bestehen,
- eine Mehrzahl erster Dioden (D1),
- eine Mehrzahl zweiter Dioden (D2),
- ein unidirektionales Begrenzerbauteil (Z),
- einen ersten Leiterbus bzw. Leiterschiene (R1),
- einen zweiten Leiterbus bzw. Leiterschiene (r2);
wobei die Schutzschaltung des weiteren so ausgebildet ist, daß
- in der aus sämtlichen Eingangs-/Ausgangs-Anschlußkontakten (P1,P2,...) und aus bestimmten Versorgungs-Anschlußkontakten (VDD₁, VDD₂,...., VSS₁, VSS₂,..) gebildeten Gesamtheit jeweils jeder Anschlußkontakt mit der Anode einer der ersten Dioden (D1) verbunden ist, deren Kathode mit dem ersten Leiterbus (R1) verbunden ist, und mit der Kathode einer der zweiten Dioden (D2) verbunden ist, deren Anode mit dem zweiten Leiterbus (R2) verbunden ist, und
- daß das unidirektionale Begrenzerbauteil (Z) mit seiner Kathode mit dem ersten Leiterbus (R1) und mit seiner Anode mit dem zweiten Leiterbus (R2) verbunden ist.

2. Schutzschaltung nach Anspruch 1, dadurch gekennzeichnet, daß sämtliche Versorgungs-Anschlußkontakte mit den ersten und zweiten Dioden in der Weise verbunden sind, wie dies in Anspruch 1 für bestimmte Versorgungs-Anschlußkontakte angegeben ist.

3. Schutzschaltung nach Anspruch 1, dadurch gekennzeichnet, daß der Hochpotential-Anschlußkontakt (VDDᵢ) der am stärksten positiven Versorgung mit dem ersten Leiterbus und der Niedrigpotential-Anschlußkontakt (VSSⱼ) der am stärksten negativen Versorgung mit dem zweiten Leiterbus verbunden sind.

4. Schutzschaltung nach Anspruch 1, dadurch gekennzeichnet, daß die Leiterbusse bzw. -schienen (R1,R2) von Leiterpfaden gebildet werden, die am Umfang der integrierten Schaltung jeweils diesseits bzw. jenseits der Anschlußkontakte ausgebildet sind.
